# EUROPÄISCHE PATENTANMELDUNG

(11) **EP 0 727 814 A1**
(43) Veröffentlichungstag der Anmeldung: **21.08.1996**
(21) Anmeldenummer: 96101891.8
(22) Anmeldetag: 09.02.1996
(51) Int. Cl.: H01L 21/00, G01B 7/34, G01N 27/00

(54) **Abtastvorrichtung zur Untersuchung von elektronischen, magnetischen und topographischen Strukturen mit Auflösungen im submicron-Bereich sowie Verfahren zu ihrer Herstellung**

(30) Priorität: 11.02.1995 DE 19504552
(71) Anmelder: INSTITUT FÜR MIKROTECHNIK MAINZ GmbH, D-55129 Mainz-Hechtsheim (DE)
(72) Erfinder: Ruf, Alexander, Dipl.-Ing., D-55128 Mainz (DE); Abraham, Michael, Dr., D-55129 Mainz (DE)
(74) Vertreter: Fuchs, Luderschmidt & Partner

(57) **Zusammenfassung**

Es wird eine Abtastvorrichtung (14) beschrieben, die sich in der Massenfertigung herstellen läßt und deren Sensor aus einem elektrisch leitenden oder magnetischen Material besteht, so daß sie zur Rasterkraft- und Rastertunnelmikroskopie eingesetzt werden kann. Der Sensor (1) wird durch galvanische Abformung einer Negativform aus einem Metall oder einer Legierung hergestellt. Der Sensor (1) kann für die Rasterkraftmikroskopie sich an einem Mikroskopbalken (6a) befinden, der durch eine leitende Schicht (10) zusätzlich den Sensor (1) kontaktieren kann, damit dieser gleichzeitig zur Rastertunnelmikroskopie eingesetzt werden kann.

## Beschreibung

Die Erfindung betrifft eine Abtastvorrichtung zur Untersuchung von elektronischen, magnetischen und topographischen Oberflächeneigenschaften und -strukturen mit Auflösungen im submicron-Bereich mit einer an einem Trägerelement, insbesondere einem Mikroskopbalken, befindlichen Sensor sowie ein Verfahren zu ihrer Herstellung.

Mit solchen Abtastvorrichtungen werden die elektronischen, magnetischen und topographischen Eigenschaften von Oberflächen mit submicron-Auflösung untersucht. Zu dieser Art der Oberflächenprofilometrie zählt die Rastertunnel- und die Rasterkraftmikroskopie (STM/AFM) (R.J.Behm, N.Garcia, H.Rohrer "Scanning Tunneling Microscopy and Related Methods", NATO ASI Series E Vol. 184, Luver Academic Publishers 1990; Dror Sarid "Scanning Force Microscopy", Oxford University !991).

Die zentrale Komponente eines Rastertunnelmikroskops besteht aus einer leitenden Sensorspitze, die in Tunnelkontakt mit der zu untersuchenden Oberfläche gebracht wird. Die heim Rastern der Spitze über die Oberfläche auftretende Änderung des Tunnelstroms wird direkt aufgezeichnet ("constant height mode") oder aber durch einen Regelkreis auf konstant zurückgeregelt und das Regelsignal aufgezeichnet ("constant current mode").

Die zentrale Komponente eines Rasterkraftmikroskops ist der Mikroskopbalken, der auf der einen Seite an einem Träger fest eingespannt ist und am anderen freien Ende einen Sensor mit einer Spitze trägt, mit der die Oberfläche abgetastet wird. Die bei Abtasten auftretenden Auslenkungen des Mikroskopbalkens werden mit geeigneten Methoden nachgewiesen. Hierzu zählen optische Methoden wie das Lichtzeigerprinzip und das unterferometrische Prinzip. Wie bei der Rastertunnelmikroskopie wird auch zwischen "constant height mode" und "constant force mode" unterschieden. Im ersten Fall wird die Auslenkung des Mikroskopbalkens direkt aufgezeichnet, im zweiten Fall wird die Auslenkung des Mikroskopbalkens auf einen konstanten Wert geregelt und das Regelsignal aufgezeichnet.

Um Oberflächen mit atomarer Auflösung abzutasten, befindet sich die Sensorspitze in Kontakt mit der Probe. Magnetische Eigenschaften der Probenoberfläche werden durch eine andere Art der Kraftmikroskopie abgebildet. Dazu befindet sich eine magnetische Sensorspitze einige Nanometer über der Probe. Der Kraftmikroskopbalken wird in Resonanzschwingungen versetzt. Durch die Änderung der magnetischen Wechselwirkung der Sensorspitze mit der Probe verschiebt sich beim Rastern die Resonanzfrequenz. Der Nachweis erfolgt mit Lock-In Technik.

Die ideale magnetische Kraftmikroskopsensorspitze besteht aus einem ferromagnetischen Material an einem nichtmagnetischen Kraftmikroskopbalken. Idealerweise ist die Magnetisierung der Sensorspitze so ausgerichtet, daß das gesamte ferromagnetische Material eine Domäne, d.h. einen magnetisch einheitlich ausgerichteten Bereich, bildet. Das konnte bisher noch nicht hergestellt werden.

Bisher sind zwei Methoden bekannt, magnetische Kraftmikroskopsensorspitzen herzustellen. Die älteste Methode besteht im elektrochemischen Anspitzen von Nickeldrähten. Diese werden dann zu Federarmen gebogen (H.J.Mamin, D.Rugar, J.E.Stern, B.D.Terris, S.E.Lambert, Appl. Phys. Lett. 53 (1988) 318). Diese Methode hat den Nachteil, daß jeder Sensor einzeln gefertigt werden muß. Zudem besteht der gesamte Mikroskopbalken aus magnetischem Material, das kann zu großen Störfeldern führen. Die angespitzten Nickeldrähte lassen sich außerdem nicht in den kommerziell vertriebenen Geräten mit Lichtzeigerdetektionsprinzip einsetzen.

Eine neuere Methode besteht im Beschichten von nichtmagnetischen Sensorspitzen mit magnetischen Materialien, wie sie z.B. in der Magnetplattenfertigung Verwendung finden (H.J.Mamin, D.Rugar, P.Gruetter, P.Guethner, S.E.Lambert, T.Yogi, O.Wolter, J.Greschner, Bull. Am. Phys. Soc. 35 (1990) 420). Diese Methode ist zwar massenfertigungstauglich, magnetisiert aber den gesamten Mikroskopbalken, so daß Streufelder entstehen. Ein weiterer Nachteil dieser Methode ist die Verschlechterung des Sensorspitzenradius durch die aufgebrachte Schicht. Die Auflösung der magnetischen Kraftmikroskopie wird aber gerade durch den Sensorpitzenradius, das gesamte wechselwirkende Magnetfeld einschließlich der Streufelder bestimmt.

Elektrisch leitende Sensoren für die Rastertunnelmikroskopie werden bisher vor allem durch Ziehen und Ätzen von metallischen Drähten hergestellt. Um solche Sensoren auch in der Rasterkraftmikroskopie verwenden zu können, muß der Draht zusätzlich zu einem Mikroskopbalken gebogen werden. Diese Methode ist nicht massenfertigungstauglich und liefert keine reproduzierbaren Spitzenradien. Die angespitzten Drähte sind zudem ungeeignet für den Einsatz in den gängigen Kraftmikroskopen der Lichtzeigermethode.

Die schon bei der magnetischen Kraftmikroskopie genannte Methode, die Sensorspitze nachträglich mit einer Schicht zu bedecken, in diesem Fall mit einer elektrisch leitenden Schicht, hat den Nachteil, daß die aufwendig hergestellte Kraftmikroskopsensorspitze durch die aufgebrachte Schicht bedeckt und der Krümmungsradius dadurch schlechter wird.

Eine weitere Methode zur Herstellung leitender Sensorspitzen besteht im nachträglichen Implantieren von Ionen in die Spitzen. Diese Methode wurde bisher vor allem bei Sensorspitzen aus Silizium angewandt. Dieses Verfahren ist massenfertigungstauglich, hat aber den Nachteil, daß die Sensorspitze durch den nachträglichen Beschuß mit Ionen zerstört bzw. schlechter wird. Zudem kann diese Methode auch nicht verhindern, daß sich eine Siliziumschicht auf der Sensorspitze bildet, was störend für die Tunnelmikroskopie ist.

In J.Vac. Sci.Technol. A 8(4), 1990 S. 3386-3396 werden weitere Verfahren zur Herstellung von Abtastvorrichtungen beschrieben, wobei zwischen integralen Bauelementen, bei denen Trägerelement und Sensor aus demselben Material bestehen, und getrennten Bauteilen unterschieden wird. Die integralen Bauteile haben den Nachteil, daß man für die Herstellung der Sensoren an das Material des Trägerelements und umgekehrt gebunden ist.

Wenn der Trägerarm und der Sensor getrennt hergestellt werden, muß der Sensor in einem zeitaufwendigen Verfahren am Trägerarm meist durch Kleben befestigt werden.

Um hier Abhilfe zu schaffen, wurden Beschichtungsverfahren wie Sputtern oder Bedampfen vorgeschlagen, die jedoch sehr teuer sind und nicht ohne Materialverlust eine selektive Beschichtung erlauben. Meist sind noch zusätzliche Bearbeitungsschritte erforderlich.

Bei den CVD-Verfahren ist die Auswahl der einsetzbaren Metalle äußerst beschränkt, wobei als weiterer Nachteil hinzukommt, daß oft extrem giftige Trägergase verwendet werden müssen. Das in J.Vac.Sci.TEchnol. A 8(4) 1990, S. 3386-3396 beschriebene LPCVD-Verfahren ermöglicht die Herstellung von Sensoren aus Wolfram, wobei aber darauf hingewiesen wird, daß die Länge des Sensors auf maximal 2µm beschränkt ist. Für die Untersuchung von stark zerklüfteten Oberflächen und um ein Aufsetzen des Mikroskopbalkens zu verhindern, sind jedoch Sensoren mit Längen > 3µm wünschenswert.

Auch die DE 4126151 A1 beschreibt die Herstellung von Abtastvorrichtungen mittels LPCVD-Verfahren, wobei integrale Bauteile gefertigt werden. In einem Si-Wafer wird durch Ätzen ein Loch erzeugt, das mittels eines LPCVD-Verfahrens mit Si₃N₄ gefüllt wird, wobei gleichzeitig auch die Umgebung des Loches beschichtet wird, um das Trägerelement herzustellen. Dieses Verfahren ist äußerst aufwendig und läßt die Kombination unterschiedlicher Materialien für den Mikroskopbalken und den Sensor nicht zu.

Aufgabe der Erfindung ist es, ein Verfahren zur Herstellung einer Abtastvorrichtung bereitzustellen, das mit wenigen Verfahrensschritten auskommt, hinsichtlich der Materialauswahl flexibler ist und beliebige Sensordimensionen ermöglicht. Insbesondere soll es mit diesem Verfahren möglich sein, magnetische oder leitende Sensorspitzen an einem unmagnetischen Mikroskopbalken zu befestigen. Es ist auch Aufgabe, eine entsprechende Abtastvorrichtung bereitzustellen.

Diese Aufgabe wird mit einem Verfahren gemäß den Merkmalen von Patentanspruch 1 gelöst. Die Abtastvorrichtung ist Gegenstand des Patentanspruchs 13.

Es hat sich gezeigt, daß die Galvanotechnik in der Herstellung von Mikrobauelementen neue Möglichkeiten eröffnet, insbesondere deswegen, weil Materialien genutzt werden können, die bisher für die Herstellung von Sensoren nicht auf einfache Weise verwendet werden konnten. Von den galvanisch abscheidbaren Materialien ist außer beispielsweise Kupfer, Nickel, Silber und Gold insbesondere NiP und NiFe zu nennen, die als sehr harte Legierungen bzw. als solche Materialien mit besonders guten magnetischen Eigenschaften bekannt sind, so daß Sensoren einerseits mit größerer Lebensdauer gefertigt werden können und sich andererseits neue Untersuchungsmöglichkeiten eröffnen. NiP und NiFe konnten bisher mit den herkömmlichen Beschichtungstechniken nur in Dicken von 0,5 - 1µm aufgebracht werden, was jedoch für die Herstellung von Sensoren nicht immer ausreichend ist.

Ferner bietet die Galvanotechnik die Möglichkeit, durch eine Kombination der benutzen Materialien Sensoren aus verschiedenen Schichten aufzubauen, die untereinander eine sehr gute Haftung aufweisen.

Ein weiterer Vorteil des Verfahrens besteht darin, daß es möglich ist, einen magnetischen Sensor an einem unmagnetischen Mikroskopbalken zu befestigen. Da das magnetische Material ein beschränktes Volumen einnimmt, kann es später durch Magnetisierung zu einer geschlossenen Domäne ausgebildet werden.

Für bestimmte Mikroskopanwendungen ist es von Vorteil, wenn das magnetische Volumen der Sensorspitze sehr gering ist. Da es möglich ist, verschiedene Materialien nacheinander abzuscheiden, wird zunächst nur eine dünne magnetische Schicht galvanisch abgeschieden, und auf diese Schicht folgt eine zweite, unmagnetische Schicht, die die gesamte Negativform ausfüllt.

Da alle zur galvanischen Abformung einsetzbaren Materialien auch elektrisch leitend sind, wird es mit diesem Verfahren weiterhin möglich, reproduzierbar und massenfertigungstauglich Tunnelmikroskopsensoren herzustellen und diese an einem Mikroskopbalken zu befestigen. Interessant sind dafür insbesondere solche Materialien, die keine Oxidoberfläche an Luft bilden.

Ein ganz neues Einsatzfeld bietet die Nanostrukturierung von Oberflächen. Hier wird durch Anlegen eines Spannungspulses Material von der Spitze auf die Probe übertragen und dadurch die Probe lokal strukturiert. Der Vorteil der erfindungsgemäßen Sensoren liegt darin, daß weitere Materialien zur Verfügung stehen, wobei auch längere Sensoren hergestellt werden können.

Ein weiteres Anwendungsfeld der Erfindung erschließt sich im Bereich der Feldemissionsspitzen. Dabei liegt der Vorteil der elektrolytisch abgeformten Sensoren in der guten Reproduzierbarkeit der Spitze und ihrer definierten Geometrie.

Ein weiterer Vorteil besteht darin, daß die Dimensionierung des Sensors beliebig gewählt werden kann. Vorteilhafterweise besitzt der Sensor ein Aspektverhältnis zwischen 1:1 und 1:10. Lange Spitzen sind von Vorteil, da auch tiefe Gräben zugänglich sind bzw. die Winkelausrichtung der Abtastvorrichtung und der Probenoberfläche weniger kritisch ist.

Vorzugsweise wird die Negativform in einem Verbund aus mindestens zwei Materialien ausgebildet, von denen ein Material elektrisch leitend ist oder in einer Schicht zur Bildung einer Elektrode für den Galvanisiervorgang elektrisch leitend gemacht wird. Vorzugsweise wird ein Verbund aus lediglich zwei Materialien verwendet, wovon ein Material den späteren Trägerarm bildet und das andere Material die Funktion der Elektrode für den Galvanisiervorgang übernimmt. Hierbei wird vorzugsweise der Abschnitt der Negativform, der die Sensorspitze bildet in das elektrisch leitende Material oder in die elektrisch leitende Schicht gelegt. Der übrige Teil der Negativform wird in dem Material ausgebildet, das den späteren Trägerarm bildet, was den Vorteil hat, daß der Sensor beim galvanischen Auffüllen der Negativform sofort mit dem Material des Trägerarms verbunden wird, ohne daß ein weiterer Verfahrensschritt zum Befestigen des Sensors am Trägerarm erforderlich wird. Für das Material, das die Funktion der Elektrode übernimmt, wird vorzugsweise Silicium verwendet, das in einer Oberflächenschicht durch n-Dotierung leitfähig gemacht wird. Dabei ist zu berücksichtigen, daß nicht jede beliebige Dotierung verwendet werden kann, da nicht alle Dotierungen nachher anisotropes Naßätzen von Silicium erlauben.

Für das zweite Material, das vorzugsweise als Maskierungsschicht auf das erste Material aufgebracht wird und den Trägerarm bildet, wird insbesondere Siliciumnitrid, Siliciumoxid oder Siliciumkarbid verwendet.

Gemäß einer bevorzugten Ausführungsform wird in einem Plättchen aus einem Halbleitermaterial durch Dotierung die leitende Schicht erzeugt, auf die leitende Schicht eine Maskierungsschicht aufgebracht und mittels einer Maske durch einen photolithographischen Prozeß mit anschließendem Ätzen der Maskierungsschicht an mindestens einem vorgegebenen Oberflächenbereich, wo der Sensor ausgebildet werden soll, ein Loch als Teil der Negativform erzeugt. Im Bereich des Loches wird in die leitenden Schicht, wo die Sensorspitze ausgebildet werden soll, die Negativform der Sensorspitze geätzt. Die Negativform wird dann galvanisch unter Ausbildung des Sensors aufgefüllt und der Sensor mit der das Trägerelement bildenden Maskierungsschicht durch Ätzen des Plättchens und der leitenden Schicht freigelegt.

Gemäß einer weiteren Ausführungsform wird in einem Plättchen aus Halbleitermaterial in mindestens einem vorgegebenen Oberflächenbereich, wo die Sensorspitze ausgebildet werden soll, mittels Ätzen eine Vertiefung als Teil der Negativform und anschließend durch Dotierung die leitende Schicht erzeugt. Auf diese leitende Schicht wird eine Maskierungsschicht aufgebracht, in der über der Vertiefung durch einen photolithographischen Prozeß mit anschließenden Ätzen ein Loch als Teil der Negativform erzeugt wird. Die Negativform wird galvanisch ebenfalls unter Ausbildung des Sensors aufgefüllt und anschließend der Sensor mit der das Trägerelement bildenden Maskierungsschicht durch Ätzen des Plättchens und der leitenden Schicht freigelegt.

Um besonders spitze Sensoren herstellen zu können, wird vorzugsweise nach dem Ätzen der Negativform die leitende Schicht in einer Oberflächenschicht thermisch oxidiert und die Oxidschicht vor dem galvanischen Abformen der Negativform durch Ätzen zumindest teilweise wieder entfernt, so daß die leitende Oberfläche im Bereich der herzustellenden Sensorspitze freigelegt wird.

Diese Verfahrensvarianten bestehen somit aus einer Kombination von Siliciummikrotechnik, Dünnschichttechnik und galvanischer Abformung. Anstelle der Herstellung einer leitenden Schicht durch Dotierung können die bevorzugten Ausführungsformen auch mit elektrisch leitendem Material durchgeführt werden, so daß der Verfahrensschritt der Dotierung eingespart werden kann.

Bei der galvanischen Abformung der Negativform des Sensors erfolgt die Abscheidung über die Maskierungsschicht hinaus, wodurch ein pilzförmiger Abschnitt des Sensors gebildet wird, der ein Herausfallen des Sensors aus dem Loch der Maskierungsschicht bzw. des Trägerarms verhindert.

Vorzugsweise wird mittels einer Maske durch einen photolithographischen Prozeß mit anschließenden Ätzen aus der Maskierungsschicht mindestens ein Trägerelement, insbesondere ein Mikroskopbalken, der an mindestens einem Ende den senkrecht zur Balkenachse angeordneten Sensor trägt, hergestellt. Hierbei ist es möglich, auch mehrere Mikroskopbalken mit gleicher oder ähnlicher Geometrie zu fertigen. Ein Halteelement wird vorzugsweise durch Bonden oder Kleben am Trägerelement, d.h. am Mikroskopbalken befestigt.

Nach der galvanischen Abformung der Negativform kann auf die Rückseite des Sensors und des Mikroskopbalkens eine Deckschicht zum Fixieren des Sensors aufgebracht werden. Diese Deckschicht kann mittels mindestens einer Maske und einer weiteren Maskierungsschicht zumindest in einem Bereich des galvanisch abgeformten Sensors durch Ätzen wiederum entfernt werden, so daß hier die Möglichkeit einer elektrischen Kontaktierung besteht. Die Rückseite des Mikroskopbalkens und des Sensors kann mit einer Beschichtung, insbesondere mit einer reflektierenden Beschichtung oder mit einer elektrisch leitenden Schicht, die den Sensor elektrisch kontaktiert, versehen werden.

Beispielhafte Ausführungsformen der Erfindung werden nachfolgend anhand der Zeichnungen näher erläutert.

Es zeigen:
- Figuren 1a-1c: die Verfahrensschritte zur Herstellung von Sensoren und Mikroskopbalken anhand von Schnittdarstellungen und Draufsichten auf den Materialverbund mit galvanisch abgeformten Sensoren,
- Figur 1d: einen Schnitt durch eine Abtastvorrichtung gemaß einer weiteren Ausführungsform,
- Figuren 2a und b: Verfahrensschritte zur Herstellung einer Abtastvorrichtung gemäß einer weiteren Ausführungsform und
- Figur 3: einen Schnitt durch einen Materialverbund zur Herstellung von besonders spitzen Sensoren.

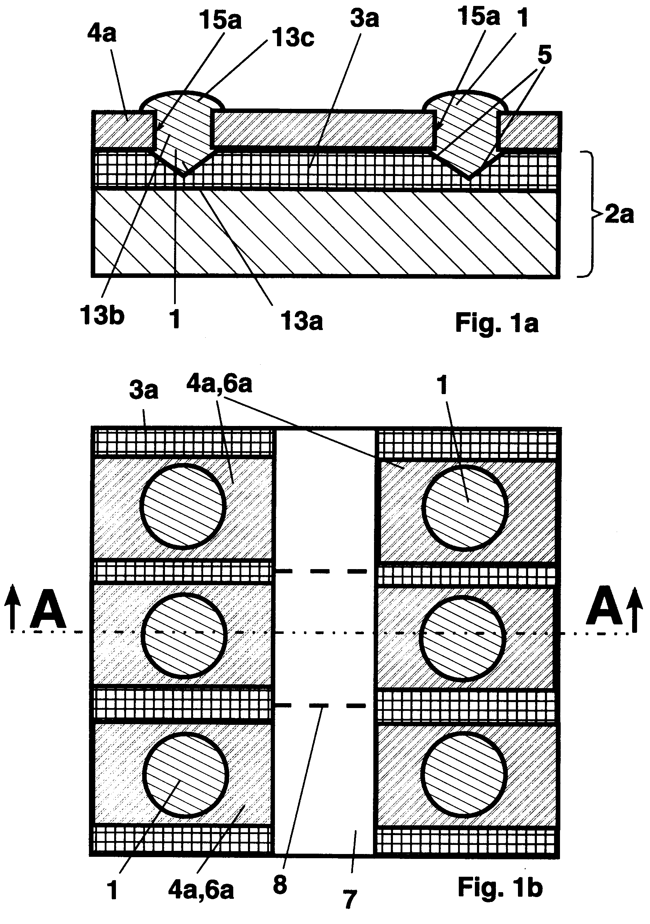

In den Figuren 1a bis 1c werden die einzelnen Verfahrensschritte zur Herstellung einer Abtastvorrichtung 14 mit Mikroskopbalken aus Siliciumnitrid und Sensor aus Metall z.B. Nickel dargestellt. Zunächst wird die oberste Schicht eines Siliciumplättchens 2a durch n-Dotierung leitfähig gemacht. Es entsteht die leitende Schicht 3a. Dabei ist zu berücksichtigen, daß nicht jede beliebige Dotierung verwandt werden kann, da nicht alle Dotierungen nachher anisotropes Naßätzen von Silicium erlauben. Weiterhin bestimmt die Teife des Dotierprofiles die mögliche Lange der Spitze. Auf die leitende Schicht 3a wird eine Maskierungsschicht 4a aus Siliciumnitrid aufgebracht.

Bei der Verwendung von Sensoren aus galvanisch abgeformten Strukturen ist es insbesondere von Vorteil, die Sensoren mit Mikroskopbalken aus Siliciumnitrid oder Siliciumcarbid zu kombinieren. Damit werden die vorteilhaften guten mechanischen Eigenschaften von mit CVD-Prozessen hergestellten Siliciumnitrid- und Siliciumcarbidschichten mit denen der galvanisch abgeformten Sensoren verbunden.

Durch einen Photolithographieprozeß mit anschließendem Trockenätzen wird in der Siliciumnitridschicht 4a ein Loch 15a erzeugt. Der Durchmesser des Loches 15a entspricht der späteren Basisbreite des Sensors. Durch anschließendes anisotropes Naßätzen wird in der dotierten Schicht 3a des Siliciumplättchens 2a der Abschnitt der Negativform für die Sensorspitze 13a erstellt.

In der Figur 1a ist die durch ein Loch 15a unterbrochene Siliciumnitridschicht 4a und die in der dotierten Schicht 3a erzeugte Negativform des Sensors dargestellt. Die Form der Sensorspitze 13a wird durch die Ätzkanten 5 des Siliciums beim anisotropen Ätzen vorgegeben. Ein geringes Unterätzen der Siliciumnitridschicht 4a ist dabei erwünscht.

Nach dem Ätzvorgang wird durch galvanische Abscheidung von Metall die Negativform des Sensors aufgefüllt. Dabei dient die leitfähige Schicht 3a des Siliciumplättchens 2a als Elektrode. Die Siliciumnitridschicht 4a verhindert, daß auch an anderen Stellen als der Negativform des Sensors Material abgeschieden wird. Die Abscheiderate kann über die elektrische Stromdichte beeinflußt werden. Dabei ist die geringe Elektrodenfläche der Negativform der Sensorspitze zu berücksichtigen. In der Figur 1a ist der Sensor 1 nach Beendigung des galvanischen Abscheidevorgangs dargestellt. Der Abscheidevorgang wurde solange fortgesetzt, bis das Metall über die Siliciumnitridschicht 4a herausgewachsen ist, so daß sich auf dem Mittelabschnitt 13b des Sensors 1 ein pilzförmiger Abschnitt 13c bildet, der die Schicht 4a übergreift. Dadurch findet eine Verzahung zwischen Sensor 1 und Siliciumnitridschicht 4a statt, die verhindert, daß der Sensor später aus der Siliciumnitridschicht 4a herausfallen kann.

Im nächsten Schritt werden die Mikroskopbalken 6a durch einen Photolithographie- und Trockenätzprozeß aus der Siliciumnitridschicht 4a erzeugt. Dabei kann die Geometrie der Mikroskopbalken 6a durch die benutze Photolithographiemaske festgelegt werden. Durch Kleben oder Bonden wird danach das Halteelement 7 angebracht.

Bei dem vorgestellten Herstellungsverfahren ist es möglich, große Halteelemente mit einer entsprechend großen Anzahl von Mikroskopbalken gleichzeitig zu fertigen, wobei nach dem Entfernen des Siliciumsubstrats die Halteelemente durch geeignete Verfahren vorzugsweise zwischen den Mikroskopbalken durchtrennt werden.

In der Figur 1b ist eine Draufsicht dargestellt, nachdem das Halteelement 7 aufgebracht wurde. Das Halteelement 7 besitzt mehrere Trennlinien 8, an denen nach Beendigung der Herstellung das Halteelement 7 durchtrennt werden kann, so daß hier insgesamt drei Abtastvorrichtungen mit jeweils zwei Mikroskopbalken 6a, an denen sich je ein Sensor 1 befindet, entstehen. Durch Drehen des Halteelementes 7 können beide Sensoren nacheinander benutzt werden.

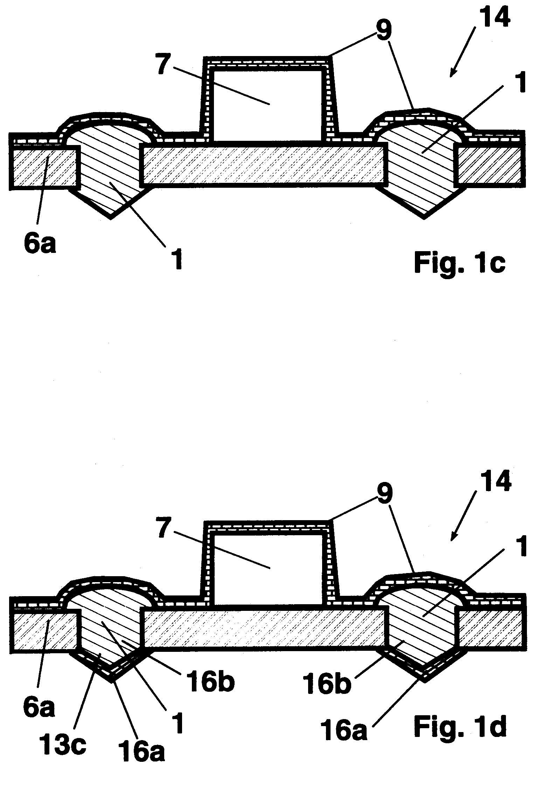

Nachdem das Halteelement 7 angebracht worden ist, wird das Siliciumplättchen 2a mit der dotierten Schicht 3a durch Ätzen entfernt. Dann liegen die Mikroskopbalken 6a mit den Sensoren 1 frei. Das ist in der Figur 1c dargestellt, die einen Schnitt durch Mikroskopbalken 6a und Sensoren 1 längs der Linie A-A in Figur 1b zeigt.

Wenn die Auslenkung des Mikroskopbalkens 6a mittels optischer Methoden nachgewiesen werden soll, ist es empfehlenswert, die Rückseite des Mikroskopbalkens mit einer reflektierenden Beschichtung zu versehen. Daher wird auf den Mikroskopbalken 6a und auf das Halteelement 7 durch Aufdampfen noch eine reflektierende Schicht 9 aufgebracht.

Für den Einsatz des Mikroskopbalkens zur Rastertunnelmikroskopie ist es sinnvoll, die Rückseite des Mikroskopbalkens mit einer leitenden Beschichtung zu versehen , die den Sensor kontaktiert. Soll der Sensor 1 zum Elektronentunneln benutzt werden, muß die reflektierende Schicht 9 daher gleichzeitig auch leitend sein und den Sensor 1 kontaktieren.

Für die magnetische Kraftmikroskopie sollte der Sensor 1 aus magnetischen Metallen oder Legierungen, wie z.B. Nickel, bestehen. Um das magnetische Volumen der Spitze zu verringern, kann der Sensor 1 auch aus zwei Schichten 16a,16b aufgebaut werden, wobei die erste Schicht 16a aus einem magnetischen Material, z.B. Nickel, der Rest des Sensors 1 aus einem unmagnetischen Material, z.B. Kupfer, besteht. Eine solche Abtastvorrichtung 14 ist in Fig. 1d dargestellt.

Für die kombinierte Rastertunnel-/Rasterkraftmikroskopsensoren sind nichtmagnetische harte Metalle von Vorteil. Die Rückseite der Sensorspitze 1 muß elektrisch aktiv bleiben und darf nicht zu schnell oxidieren. Geeignete Metalle sind Gold und Silber. Als harte Legierung kommt Nickel-Phospor in Frage. Es ist auch möglich, durch eine Kombination der benutzten Materialien Sensorspitzen aus verschiedenen Schichten aufzubauen. Dadurch läßt sich eine Oxidation oder eine chemische Veränderung beim späteren Gebrauch der Spitzenoberfläche verhindern.

Beim vorgestellten Verfahren ist die Lange der Sensorspitze 13a auf die Dicke der leitenden Schicht beschränkt. Für längere Sensorspitzen ist es daher von Vorteil, die Dotierung der obersten Schicht des Siliciumplättchens erst nach der Erstellung der Negativform des Sensors durchzuführen. Danach wird eine Siliciumnitridschicht aufgebracht und so strukturiert, daß die Negativform des Sensors freigelegt wird.

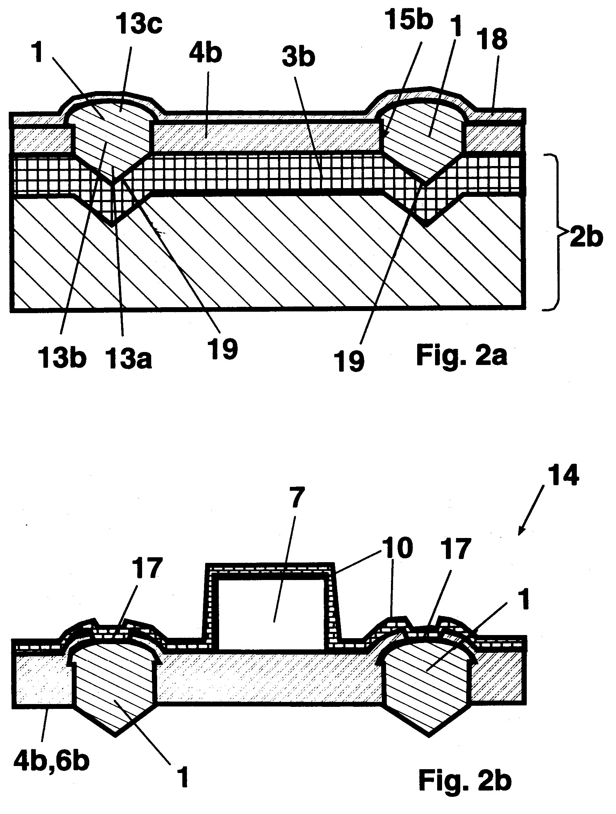

Die Herstellung von Halteelement, Mikroskopbalken und Sensorspitze durch nachträgliches Dotieren ist in den Figuren 2a und 2b dargestellt. Als Schnitt ist in Figur 2a ein Siliciumplättchen 2b zu sehen, in dem durch anisotropes Ätzen eine Vertiefung 19 zur Bildung des Abschnitts der Negativform für die Sensorspitze 13a erzeugt wurde. Das kann mit dem schon oben verwendeten bekannten Verfahren geschehen.

Im nächsten Schritt wird die Oberschicht 3b des jetzt strukturierten Siliciumplättchens 2b durch Dotieren leitfähig gemacht. Auf die leitfähige Schicht 3b wird eine Schicht 4b aus Siliciumnitrid aufgebracht. Danach wird die Siliciumnitridschicht 4b über der Negativform der Sensorspitze durch einen Photolithographie- und Trockenätzprozeß entfernt, so daß ein Loch 15b entsteht.

Jetzt wird die Negativform des Sensors metallisch aufgefüllt. Das ist in Figur 2a dargestellt, nachdem der Abscheidungsprozeß beendet ist. Der Sensor 1 ist dabei ebenfalls über die Siliciumnitridschicht 4b hinaus zur Ausbildung des pilzförmigen Abschnitts 13c gewachsen. Nach dem galvanischen Auffüllen der Negativform wird eine Deckschicht 18 aus Siliciumnitrid aufgebracht. Diese verhindert, daß der Sensor 1 aus dem Loch 15b in der Siliciumnitridschicht 4b, aus der der Mikroskopbalken 6b gebildet wird, herausfällt.

Es folgt dann von oben die Strukturierung der Mikroskopbalken 6b durch einen Photolithographie- und Trockenätzprozeß. Dabei wird auch ein Teil der Rückseite des Sensors im Bereich 17 (s. Fig. 2b) freigelegt, damit diese später elektrisch leitend kontaktiert werden kann. Das Halteelement 7 wird durch Bonden oder Kleben angebracht. Es besitzt wie im vorherigen Beispiel auch Trennlinien, an denen es später durchtrennt werden kann, so daß einzelne Abtastvorrichtungen 14 entstehen.

Nun wird das Siliciumplättchen 2b und die leitende Schicht 3b durch Ätzen entfernt und damit der Mikroskopbalken 6b mit dem Sensor 1 freigelegt. In der Figur 2b ist ein Schnitt durch die freigelegten Mikroskopbalken 6b und Sensor 1 zu sehen. Zur elektrischen Kontaktierung des Sensors im Bereich 17 wird die Rückseite mit einer Metallschicht 10 bedampft.

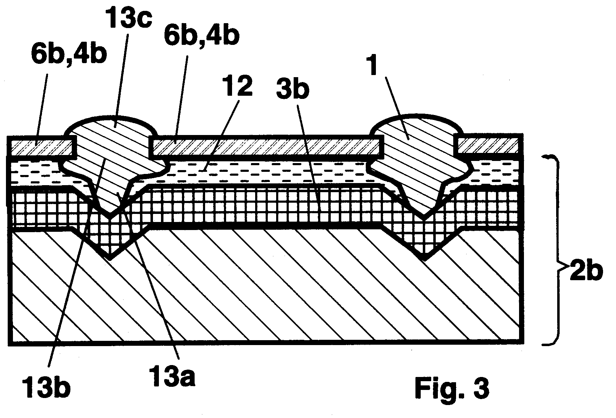

Für die Abbildung von Oberflächen mit großen Aspektverhältnissen ist es vorteilhaft, die Negativform des Sensors anzuspitzen. Dazu kann die thermische Oxidation der Siliciumoberfläche ausgenutzt werden (S.Akamine, S.F.Quate: Low temperature thermal oxidation sharpening of microcast tips; J.Vac.Sci.Technol. B 10(5) (1992) 2307). In der Figur 3 ist ein typisches Verfahren beschrieben, wie sich die Form der Sensorspitze durch einen thermischen Oxidationsprozeß der Oberfläche des benutzen Siliciumplättchens verbessern läßt.

Dazu werden zunächst die Vertiefungen 19 durch anisotropes Ätzen in der Siliciumplättchenoberfläche 2b erstellt. Das geschieht mit dem oben beschriebenen Verfahren. Anschließend wird die oberste Schicht 3b des Siliciumplättchens 2b durch Dotierung leitfähig gemacht.

Danach wird eine Oberflächenschicht 12 der Schicht 3b des Siliciumplättchens 2b thermisch oxidiert. Da das Oxid an den Kanten stärker wächst, entsteht eine Verengung des Basis der Sensorspitze 13a. In der Figur 3 ist die Oxidschicht 12, die an Kanten dicker ausgebildet wird, dargestellt. Anschließend wird großflächig eine Siliciumnitridschicht 4d aufgebracht und diese durch einen Photolithographie- und Trockenätzprozeß an der Stelle der Negativform des Sensors entfernt.

Durch isotropes Naßätzen wird das Siliciumoxid in der Schicht 12 soweit entfernt, daß die leitende Oberfläche an der Spitze der Negativform der Sensorspitze 13a wieder freiliegt. In der Figur 3 ist dargestellt, wie mit einem isotropen Naßätzprozeß die Siliciumschicht 12 soweit entfernt wird, daß an der Sensorspitze 13a die leitende Schicht 3b des Siliciumplättchens 2b freiliegt. Jetzt wird die Negativform der verbesserten Sensorspitze 1 galvanisch mit Metall gefüllt.

### Bezugszeichen:

- 1: Sensor
- 2a,b: Plättchen
- 3a,b: Oberste Schicht des Siliziumplättchen
- 4a,b: Maskierungsschicht
- 5: Ätzkanten
- 6a,b: Mikroskopbalken
- 7: Haltelement
- 8: Trennlinien
- 9: reflektierende Beschichtung
- 10: leitende Schicht
- 12: Siliziumschicht
- 13a: Sensorspitze
- 13b: Mittelteil
- 13c: pilzförmiger Abschnitt
- 14: Abtastvorrichtung
- 15: Loch
- 16a,b: Schicht
- 17: freigelegter Bereich
- 18: Deckschicht
- 19: Vertiefung

## Patentansprüche

1. Verfahren zur Herstellung einer Abtastvorrichtung (14) zur Untersuchung von elektronischen, magnetischen und topographischen Oberflächeneigenschaften und -strukturen mit Auflösungen im submicron-Bereich mit einem an einem Tägerelement, insbesondere einem Mikroskopbalken (6a,b) befindlichen Sensor (1), dadurch gekennzeichnet,
daß mindestens der Sensor (1) durch galvanisches Abformen einer Negativform hergestellt wird.

2. Verfahren nach Anspruch 1, dadurch gekennzeichnet, daß die Negativform in einem Verbund aus mindestens zwei Materialien ausgebildet wird, von denen ein Material elektrisch leitend ist oder in einer Schicht (3a,b) zur Bildung einer Elektrode für den Galvanisiervorgang elektrisch leitend gemacht wird.

3. Verfahren nach Anspruch 1 oder 2, dadurch gekennzeichnet, daß der Abschnitt der Negativform, der die Sensorspitze (13a) bildet, in das elektrisch leitende Material oder in die elektrisch leitende Schicht (3a,b) gelegt wird.

4. Verfahren nach einem der Ansprüche 2 oder 3, dadurch gekennzeichnet, daß in einem Plättchen (2a) aus einem Halbleitermaterial durch Dotierung die leitende Schicht (3a) erzeugt wird,
daß auf die leitende Schicht (3a) eine Maskierungsschicht (4a) aufgebracht wird,
daß mittels einer Maske durch einen photolithographischen Prozeß mit anschließendem Ätzen der Maskierungsschicht (4a) an mindestens einem vorgegebenen Oberflächenbereich, wo der Sensor (1) ausgebildet werden soll, ein Loch (15a) als Teil der Negativform erzeugt wird,
daß im Bereich des Loches (15a) in die leitende Schicht (3a), wo die Sensorspitze (13a) ausgebildet werden soll, die Negativform der Sensorspitze (13a) geätzt wird,
daß die Negativform galvanisch unter Ausbildung des Sensors (1) aufgefüllt wird und
daß der Sensor (1) mit der das Trägerelement (6a) bildenden Maskierungsschicht (4a) durch Ätzen des Plättchens (2a) und der leitenden Schicht (3a) freigelegt wird.

5. Verfahren nach einem der Ansprüche 1 bis 3, dadurch gekennzeichnet, daß in einem Plättchen (2b) aus Halbleitermaterial an mindestens einem vorgegebenen Oberflächenbereich, wo die Sensorspitze (13a) ausgebildet werden soll, mittels Ätzen eine Vertiefung (19) als Teil der Negativform erzeugt wird,
daß durch Dotierung die leitende Schicht (3b) erzeugt wird,
daß auf die leitende Schicht (3b) eine Maskierungsschicht (4b) aufgebracht wird, in die über der Vertiefung (19) durch einen photolithographischen Prozeß mit anschließendem Ätzen ein Loch (15b) als Teil der Negativform erzeugt wird,
daß die Negativform galvanisch unter Ausbildung des Sensors (1) aufgefüllt wird und
daß der Sensor (1) mit der das Trägerelement (6b) bildenden Maskierungsschicht (4b) durch Ätzen des Plättchens (2b) und der leitenden Schicht (3b) freigelegt wird.

6. Verfahren nach Anspruch 5, dadurch gekennzeichnet, daß nach dem Ätzen der Negativform die leitende Schicht (3b) in einer Oberflächenschicht thermisch oxidiert wird und
daß die Oxidschicht (12) vor dem galvanischen Abformen der Negativform durch Ätzen zumindest teilweise wieder entfernt wird, so daß die leitende Oberfläche im Bereich der herzustellenden Sensorspitze (13a) freigelegt wird.

7. Verfahren nach einem der Ansprüche 2 bis 6, dadurch gekennzeichnet, daß bei der galvanischen Abformung der Negativform des Sensors (1) die Abscheidung über die Maskierungsschicht (4a,b) hinaus erfolgt.

8. Verfahren nach einem der Ansprüche 1 bis 7, dadurch gekennzeichnet, daß mittels einer Maske durch einen photolithographischen Prozeß mit anschließendem Ätzen aus der Maskierungsschicht (4a,b) mindestens ein Trägerelement (6a,b), insbesondere ein Mikroskopbalken, der an mindestens einem Ende den senkrecht zur Balkenachse angeordneten Sensor (1) trägt, hergestellt wird.

9. Verfahren nach einem der Ansprüche 1 bis 8, dadurch gekennzeichnet, daß nach der galvanischen Abformung der Negativform auf die Rückseite des Sensors (1) eine Deckschicht (18) aufgebracht wird.

10. Verfahren nach Anspruch 9, dadurch gekennzeichnet, daß die Deckschicht (18) mittels mindestens einer Maske und einer weiteren Maskierungsschicht zumindest in einem Bereich (17) des galvanisch abgeformten Sensors (1) durch Ätzen entfernt wird.

11. Verfahren nach einem der Ansprüche 1 bis 10, dadurch gekennzeichnet, daß der Mikroskopbalken (6a,b) oder der Sensor (1) mindestens auf seiner Rückseite mit einer Beschichtung, insbesondere einer reflektierenden Beschichtung (9) oder einer elektrisch leitenden Schicht (10), die den Sensor (1) elektrisch kontaktiert, versehen wird.

12. Verfahren nach einem der Ansprüche 1 bis 11, dadurch gekennzeichnet, daß beim galvanischen Auffüllen der Negativform nacheinander mindestens zwei Schichten (16a,b) galvanisch abgeschieden werden.

13. Abtastvorrichtung zur Untersuchung von elektronischen, magnetischen und topographischen Oberflächeneigenschaften und -strukturen mit Auflösung im submicron-Bereich mit einem an einem Trägerelement, insbesondere einem Mikroskopbalken (6a,b) befindlichen Sensor (1), dadurch gekennzeichnet,
daß mindestens der Sensor (1) aus galvanisch abscheidbarem Material besteht.

14. Abtastvorrichtung nach Anspruch 13, dadurch gekennzeichnet, daß der Sensor (1) aus Cu, Ni, Ag, NiP, NiFe einzeln oder in Kombination besteht.

15. Abtastvorrichtung nach Anspruch 13 oder 14, dadurch gekennzeichnet, daß der Sensor (1) ein Aspektverhältnis 1:1 bis 1:10 aufweist.
